# EUROPEAN PATENT APPLICATION

(11) **EP 0 731 506 A2**
(43) Date of publication of application: **11.09.1996**
(21) Application number: 96301502.9
(22) Date of filing: 05.03.1996
(51) Int. Cl.: H01L 23/498, H01L 21/60

(54) **Package for semiconductor device**

(30) Priority: 08.03.1995 JP 48079/95
(71) Applicant: SHINKO ELECTRIC INDUSTRIES CO. LTD., Nagano-shi, Nagano 380 (JP)
(72) Inventor: Takeuchi, Yukiharu, c/o Shinko Elec. Ind. Co. Ltd., Oaza Kurita, Nagano-shi, Nagano (JP)
(74) Representative: Rackham, Stephen Neil

(57) **Abstract**

A semiconductor package includes a resin film (12) having an upper surface on which conductive patterns (18) are formed and a semiconductor element (16) is to be mounted. A base substrate (10) has an upper surface on which intermediate conductive patterns (27) are formed and a lower surface on which external terminal connecting pads (24), to which external terminals (26) are to be connected, are formed. The intermediate conductive patterns (27) are electrically connected to the external terminal connecting pads (24) by means of vias (20) provided in the base substrate (10). An adhesive layer (14) adheres the lower surface of the resin film (12) to the upper surface of the base substrate (10). Conductors (30,36,42) provided in through holes (28) penetrate through the resin film (12) and preferably through the adhesive layer (14) to electrically connect the conductive patterns (18) on the upper surface of the resin film (12) to the external terminal connecting pads (24) on the lower surface of the base substrate (10) by means of the intermediate conductive patterns (27) on the upper surface of the base substrate (10).

## Description

The present invention relates to a package for semiconductor devices, a process for making the same, and a semiconductor device using such a package. More particularly, this invention relates to a package, a process for making the same, and a semiconductor device, in which conductive patterns are formed on a first surface of the package for mounting thereon a semiconductor element and external terminal connecting pads are formed on a second, opposite surface of the package.

In a semiconductor package conventionally known in the prior art, ceramic substrates and glass-fiber reinforced (glass epoxy) resin substrates have been advantageously used as a base substrate on which a semiconductor element or chip is mounted.

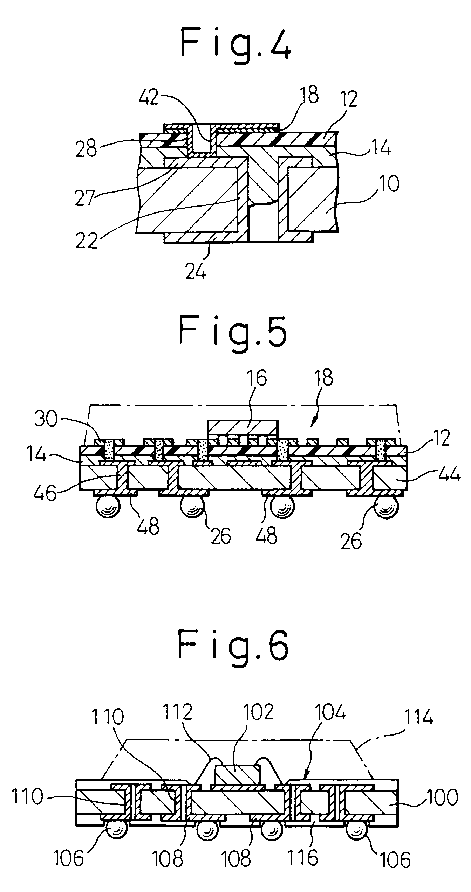

An example of such a semiconductor package known in the prior art is shown in Fig. 6, in which a base substrate 100 is made of a glass-fiber reinforced resin.

In Fig. 6, conductive patterns 104 are formed on the upper surface of the package for mounting thereon a semiconductor element 102 and terminal connecting pads 108, 108, ... are formed on the opposite, lower surface of the package for electrically connecting thereto external connecting terminals 106, 106, ... The conductive patterns 104 are electrically connected to the terminal connecting pads 108, 108 by means of vias 110, 110, ... provided in the resin substrate 100.

The semiconductor element 102 mounted on the resin substrate 100 is hermetically sealed with a sealing resin to complete a semiconductor device, in which the semiconductor element 102 is electrically connected to the conductive patterns 104 by bonding-wires, in the example of Fig. 6.

The glass fiber reinforced resin substrate 100 has upper and lower surfaces which are both coated with copper foils and provided with through holes. The inner walls of the through holes are plated with a metal (copper) to define conductive vias 110, 110, ... The copper plated layers for defining these conductive vias 110, 110, ... are formed by first electroless plating and then electroplating. The metal plated layers are also formed to a certain thickness on the copper foils of the upper and lower surfaces of the resin substrate 100.

Then, the copper foils with plate copper layers are etched to form conductive patterns 104 on the upper surface and terminal connecting pads 108, 108, ... on the opposite, lower surface of the resin substrate. The surface of the resin substrate on which the terminal connecting pads 108, 108 ... are formed is coated with solder resist except for the areas to which the external connecting terminals 106, 106, ... are to be connected.

Since the semiconductor package as mentioned above comprises a base substrate 100 which is made of a glass fiber reinforced resin, it is possible to obtain a light weight package having a simple structure.

The conductive vias 110, 110, ... are defined by the copper plated layers 118 directly formed on the inner walls of the through holes of the resin substrate 100. Thus, the copper plated layers are also formed on the surface of the resin substrate 100 on which said terminal pads 108, 108 are formed, as mentioned above.

The respective terminal pads 108, 108 are subjected to a thermal stress or the like when the external connecting terminals 106 are attached thereto. Thus, it is required to increase the thickness of the connecting pads 108, i.e., the thickness of the copper plated layer, so as to improve the thermal durability of the connecting pads 108. In the same manner, it is also required to increase the thickness of the copper plated layer on the inner walls of the through holes to improve the durability thereof.

However, if the thickness of the copper plated layers 118 is increased, the thickness of the conductive patterns of the glass fiber reinforced resin substrate will also be increased, since the copper plated layer 118 is overlapped on the cooper foils previously coated on the resin substrate.

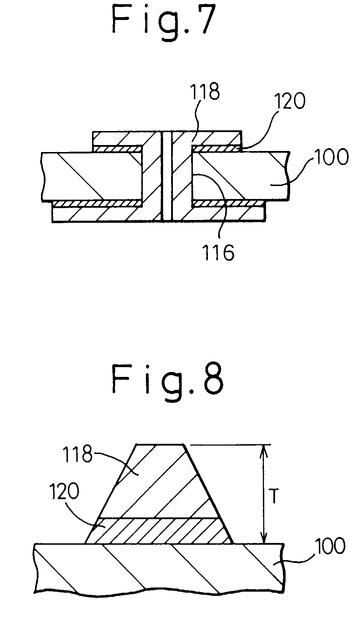

Therefore, when a relatively thick copper layer is etched to form the conductive pattern, the conductive pattern becomes trapezoidal in cross-sectional as shown in Fig. 8. Thus, it is difficult to form fine patterns on the resin substrate, as shown in Fig. 8, in which the thickness of the copper layer is T, i.e., the total thickness of the copper plated layer 118 and the copper foil 120.

On the other hand, the semiconductor element 102 is a so-called flip-flop type, in which the semiconductor chip which is to be mounted on the package has a plurality of electrodes, such as solder balls, so that the semiconductor chip can be directly mounted on and connected to the conductive patterns on the resin substrate. Thus, it is required that the conductive patterns 104 on the resin substrate on which a semiconductor element is mounted must be as fine as possible.

According to the present invention, there is provided a semiconductor package comprising: a resin film having a first, upper surface on which conductive patterns are formed and at least one semiconductor element is to be mounted and a second, lower surface; a base substrate having a first, upper surface on which intermediate conductive patterns are formed and a second, lower surface on which external terminal connecting pads to which external terminals are to be connected are formed, said intermediate conductive patterns are electrically connected to said external terminal connecting pads by means of vias provided in said base substrate; an adhesive layer for adhering said second, lower surface of the resin film to said first, upper surface of the base substrate; and connecting means provided in through holes penetrating through said resin film and said adhesive layer for electrically connecting said conductive patterns on said first, upper surface of the resin film to said external terminal connecting pads on said second, lower surface of the base substrate by means of said intermediate conductive patterns on the first, upper surface of the base substrate.

According to another aspect of the present invention, said connecting means comprises through holes penetrating through said resin film, metal plated layers formed on inner walls of said through holes, and portions of said anisotropic conductive adhesive paste corresponding to said through holes.

In one embodiment, said conductive patterns on the first, upper surface of the resin film are finer than said intermediate conductive patterns on the first, upper surface of the base substrate.

In one embodiment, each of said vias provided in the base substrate comprises a through hole provided in said base substrate and a metal plated layer formed on an inner wall of said through hole.

In another embodiment, each of said vias provided in the base substrate comprises a through hole provided in said base substrate, said through hole being filled with conductive paste.

In one embodiment, said connecting means for electrically connecting said conductive patterns to said external terminal connecting pads comprises said through holes penetrating through said resin film and said adhesive layer, said through holes being filled with conductive paste.

In another embodiment, said connecting means for electrically connecting said conductive patterns to said external terminal connecting pads comprises said through holes penetrating through said resin film and said adhesive layer and metal plated layers formed on inner walls of said through holes.

In one embodiment, said base substrate comprises a glass fiber reinforced plastic substrate.

In another embodiment, said base substrate comprises a ceramic substrate.

According to still another aspect of the present invention, there is provided a process for making a semiconductor package comprising: preparing a base substrate having a first, upper surface on which intermediate conductive patterns are formed and a second, lower surface on which external terminal connecting pads to which external terminals are to be connected are formed, said intermediate conductive patterns are electrically connected to said external terminal connecting pads by means of vias provided in said base substrate; preparing a resin film having a first, upper surface on which conductive patterns are formed and a second, lower surface; adhering said second, lower surface of the resin film to said first, upper surface of the base substrate by means of an adhesive layer; providing through holes so as to penetrate through said resin film and said adhesive layer at positions corresponding to said intermediate conductive patterns of the base substrate; and filling said through holes with conductive paste so as to electrically connect said conductive patterns on said first, upper surface of the resin film to said external terminal connecting pads on said second, lower surface of the base substrate by means of said intermediate conductive patterns of the base substrate.

In one embodiment, said process comprises forming metal plated layers on the inner walls of said through holes so as to electrically connecting said conductive patterns on said first, upper surface of the resin film to said external terminal connecting pads on said second, lower surface of the base substrate by means of said intermediate conductive patterns of the base substrate.

In another embodiment, said process comprises providing through holes so as to penetrate through said resin film at positions corresponding to said intermediate conductive patterns of the base substrate; and forming metal plated layers on the inner walls of said through holes so as to electrically connect said conductive patterns on said first, upper surface of the resin film to said external terminal connecting pads on said second, lower surface of the base substrate by means of said anisotropic conductive adhesive paste and said intermediate conductive patterns of the base substrate.

According to further aspects of the present invention, there is provided a semiconductor device comprising: a resin film having a first, upper surface on which conductive patterns are formed and at least one semiconductor element is to be mounted and a second, lower surface; a base substrate having a first, upper surface on which intermediate conductive patterns are formed and a second, lower surface on which external terminal connecting pads to which external terminals are to be connected are formed, said intermediate conductive patterns are electrically connected to said external terminal connecting pads by means of vias provided in said base substrate; an adhesive layer for adhering said second, lower surface of the resin film to said first, upper surface of the base substrate; connecting means provided in through holes penetrating through said resin film and said adhesive layer to electrically connect said conductive patterns on said first, upper surface of the resin film to said external terminal connecting pads on said second, lower surface of the base substrate by means of said intermediate conductive patterns on the first, upper surface of the base substrate; said at least one semiconductor element mounted on said conductive patterns on the first, upper surface of the resin film; a sealing resin for hermetically sealing so as to cover at least said semiconductor element.

In one embodiment, said connecting means comprises through holes penetrating through said resin film, metal plated layers formed on inner walls of said through holes, and portions of said anisotropic conductive adhesive paste corresponding to said through holes.

Embodiments in accordance with this invention will now be described and contrasted with the prior art with reference to the accompanying drawings; in which:-
Figure 1 is a vertical cross-sectional view of an embodiment of a package for semiconductor devices of this invention;
Figure 2 is a partial cross-sectional view showing means for electrically connecting the conductive pattern on the resin film to the intermediate conductive pattern on the substrate body;
Figure 3 is a partial cross-sectional view showing another means for electrically connecting the conductive pattern on the resin film to the intermediate conductive pattern on the substrate body;
Figure 4 is a partial cross-sectional view showing still another means for electrically connecting the conductive pattern on the resin film to the intermediate conductive pattern on the substrate body;
Figure 5 is a vertical cross-sectional view of a package of another embodiment of this invention.
Figure 6 is a vertical cross-sectional view of an embodiment of a package for semiconductor devices known in the prior art;
Figure 7 is a partial cross-sectional view showing a structure of via formed on a substrate body in the package of the prior art; and
Figure 8 is an enlarged cross-sectional view showing a conductive pattern formed on the substrate for forming the package of the prior art.

In the embodiments, a ball-grid array (BGA) type semiconductor device will be described, although this invention can also be applied to any other type of semiconductor device, such as a pin-grid array (PGA) type semiconductor, or the like.

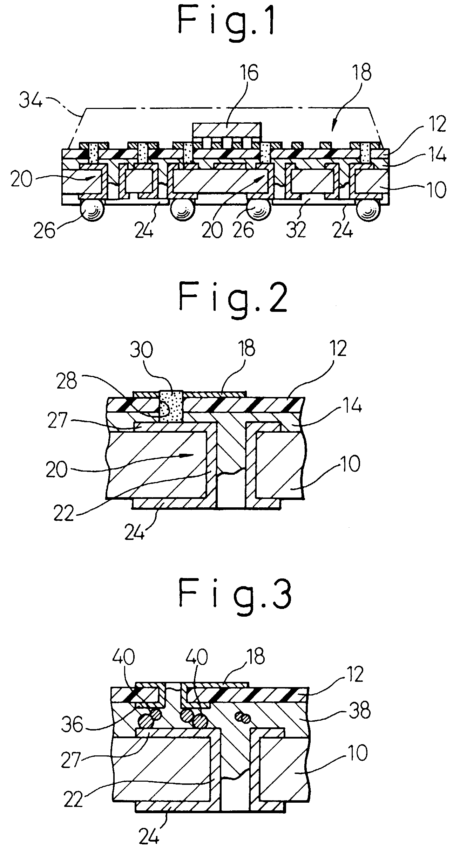

In Fig. 1, an embodiment of a package for semiconductor devices of this invention is shown. A base substrate 10 is made of glass fiber reinforced resin (glass epoxy). An insulative resin film 12 is made of polyimide or the like and has a mounting surface thereof with conductive patterns 18. The insulative resin film 12 is adhered to an upper surface of the base substrate 10 by means of an adhesive layer 14.

A semiconductor element 16 is mounted on a predetermined position of the resin film 12 by a bonding process, a so-called flip-chip type bonding, in such a manner that connecting terminals of electrodes, such as solder balls, of the element 16 are directly connected to the conductive patterns 18.
The base substrate 10 is provided with vias 20, 20, ... of a metal layer 22, which extend from the upper surface to the lower surface of the base substrate 10, as shown in Fig. 2. One end of the metal layer 22 is provided with terminal pads 24 on the second, lower surface of the base substrate 10. External connecting terminals 26, such as solder balls, are mounted on the respective terminal pads 24, 24, ...

The other end of the metal layer 22 forming vias 20 extends to the lower surface of the base substrate 10 and is provided with connecting pads 27 which are electrically connected to the conductive pattern 18 formed on the mounting surface of the resin film 12 adhered to the base substrate 10.

As shown in Fig. 2, the connecting pads 27 are electrically connected to the conductive patterns 18 of the resin film 12 by means of filled layers 30 of conductive paste which are filled in through holes 28 extending through the resin film 12 and the adhesive layer 14.

The electrical connection between the connecting pads 27 and the conductive pattern 18 can easily be attained by these filled layers 30 as mentioned above and, therefore, it is not necessary to provide any metal plated layer on the connecting pads 27.

In the semiconductor device package as shown in Figs. 1 and 2, the base substrate 10 is first formed as follows.

A glass fiber reinforced resin plate having copper foils adhered to the respective surfaces thereof is drilled to provide a plurality of through holes. The resin plate is electroless plated with copper on the inner surfaces of the through holes to provide vias 20, 20, ... In general, after the electroless plating process, an electro-plating is further conducted to obtain these vias. The metal layer 22 is also layered on the copper foils on the upper and lower surfaces of the resin plate.

Then, the intermediate conductive patterns including the connecting pads 27 are formed on one of the surfaces of the resin plate and the terminal pads 24 are simultaneously formed on the second, lower surface of the resin plate by applying an etching process to the resin plate having copper foils on which the metal layer 22 is formed.

The insulative resin film 12 is formed as follows. A resin film having one surface thereof to which a copper foil is adhered is provided with through holes at predetermined positions. The conductive patterns 18 are then formed by an etching process. The through holes can also be formed after the conductive pattern 18 is formed by the etching process.

In this manner, since the conductive pattern 18 can be formed directly by etching without layering the metal layer 22, the transverse cross-section of the conductive patterns 18 can be made as substantially rectangular shapes. Thus, the conductive patterns 18 can be made as fine patterns on the one surface of the resin film 12. Particularly, among the conductive pattern 18 formed on the one surface of the resin film 12, the conductive pattern 18 in the area where the semiconductor element is placed can be made finer than the conductive patterns 18 around the element mount area.

In the resin film 12 of this embodiment, the through holes are arranged outside of the element mounting area, where the conductive pattern 18 is formed fine. Thus, the through holes can easily be provided and also the electrical connection between the conductive patterns 18 and the terminal pads 24 can easily be attained.

The second, lower surface of the insulative resin film 12 is adhered by means of the adhesive layer 14 to the first surface of the base substrate 10 on which the intermediate conductive patterns 27 are formed. Any adhesive which has been conventionally known and used in semiconductor packages can be employed as the adhesive layer 14 in this embodiment. For example, the adhesive layer 14 can be formed on a predetermined position in the base substrate 10 by coating with an adhesive in a screen printing process or the like.

When coating with the adhesive, through holes 28 are formed so as to extend through the resin film 12 and the adhesive layer 14, so that the adhesive does not exist at the positions corresponding the through holes 28 of the resin film 12.

It is also possible that such an adhesive layer is formed on the second, lower surface of the resin film 12.

In this embodiment, the through holes 28 are filled with filling layer 30 made of conductive paste, so that the electrical connection between the connecting pads 27 and the conductive pattern 18 can be attained and, therefore, the electrical connection between the connecting pads 27 and the conductive pattern 18 and the terminal pads 24 can also be attained.

In order to prevent an oxidization of copper foil and the like, a solder resist is coated on the surface of the base substrate 10, on which the terminal pads 24 are formed, except for the portions on which the external connecting terminals 26, such as solder balls, are to be connected at a later stage. After that, the semiconductor element 16 is mounted on the base substrate 10 in such a manner that the terminals, such as solder balls, formed on the terminals of the semiconductor element 16 are directly in contact at a predetermined position with the conductive pattern 18 of the resin film 12.

Then, the semiconductor element 16 mounted on the conductive pattern 18 is hermetically sealed with a sealing resin layer 34. Then, the external connecting terminals 26, such as solder balls, are mounted on the predetermined terminal pads 24. When the external connecting terminals 26 are mounted, even if heat is applied to the terminal pads 24, the terminal pads 24 have a sufficient thickness and the vias are satisfactorily durable.

The semiconductor element 16 can also be sealed with a cap or the like (not shown) in place of the sealing resin layer 34.

In the semiconductor package as shown in Figs. 1 and 2, although the resin film 12 is adhered to the base substrate 10 by means of the adhesive layer 14 and the connecting pads 27 are electrically connected to the conductive patterns 18 by means of filing layers 30 of conductive paste, an anisotropic conductive paste can also be used as the adhesive layer 14, as the embodiment shown in Fig. 3.

The anisotropic conductive paste is a substance in which conductive particles, such as carbon particles or metal particles, are dispersed in an adhesive material, so that the substance is usually not electrically conductive. However, if a pressure is exerted to the substance, the fluid component of the adhesive material in that portion moves away and, on the other hand, the conductive particles come into contact with each other. Thus the portion of the substance where the pressure is exerted becomes electrically conductive.

When such an anisotropic conductive paste is used, it is preferable that the connecting pads 36 formed on the abutting surface of the resin film 12 are connected to the conductive patterns 18 on the upper surface of the resin film 12 by means of thin metal layers formed on the inner walls of the through holes in the resin film 12. These thin metal layers can be formed by a metal plating process, such as an electroless plating.

Then, the abutting surface of the resin film 12 is adhered to the surface of the base substrate 10 on which the connecting pads 27 are formed by means of the adhesive layer 38 consisting of the anisotropic conductive paste, as shown in Fig. 3.

Then, pressure and heat are applied to the portions of the connecting pads 36 and the resin film 12 which are arranged in conformity with the connecting pads 27 of the base substrate 10. Thus, in the pressed portions, the fluid adhesive material moves away and, on the other hand, the conductive particles 40, 40, ... come into contact with each other. Thus, the connecting pads 27 of the base substrate 10 and the connecting pads 36 of the resin film 12 can be electrically connected to each other.

In place of the filled layers 30 of conductive paste in the embodiment shown in Figs. 1 and 2, thin metal layers 42 can be formed on the inner walls of the through holes 28 extending through the resin film 12 and the adhesive layer 14 to electrically connect the connecting pads 27 of the base substrate 10 to the connecting pads of the resin film 12. The thin metal layers 42 can be formed by electroless plating. When the electroless plating is performed, a suitable mask is usually used to cover the portions where forming such metal layers is unnecessary.

Although, in the semiconductor packages as mentioned above with reference to Figs. 1 to 4, a base substrate 10 made of resin is employed, a ceramic base substrate 44 can also be employed in place of the resin substrate 10, as shown in Fig. 5.

The ceramic base substrate 44 has a plurality of vias 46, which are formed as follows. A ceramic green sheet is first drilled to arrange a plurality of through holes at predetermined positions, the through holes are filled with metallized paste, and then the green sheet is fired simultaneously with the metallized paste. The intermediate conductive patterns 44, the terminal pads 48 and the like are also formed by arranging the metallized paste at predetermined positions of the green sheet and simultaneously firing the green sheet with these patterns of the metallized paste.

In the same manner as the previous embodiments of the semiconductor packages as shown in Figs. 1 to 4, an insulative resin film 12 is adhered to the ceramic base substrate 44 obtained as mentioned above. Conductive patterns are formed on one of the surfaces of the resin film 12. The other surface of the resin film 12 is adhered to the ceramic base substrate 44 by means of an adhesive layer 14. Then, the through holes extending through the ceramic base substrate 44 and the resin film 12 are filled with conductive paste to form filled layers 30. Thus, the conductive patterns 18 are electrically connected to the terminal pads 48.

Although, in the above-mentioned embodiments, a ball-grid array (BGA) type semiconductor package employing solder balls as the external connecting terminals has been described in detail, this invention can also be applied to any other type of semiconductor package.

Some examples of the other type of semiconductor package are as follows. For instance, this invention can also be applied to a pin-grid array (PGA) type semiconductor package in which pins are used in as the external connecting terminals, a land-grid array (LGA) type semiconductor package in which conductive lands are used in as the external connecting terminals, a leadless chip carrier (LCC) type semiconductor package in which semicircular shaped external connecting terminals are provided on the side faces of the base substrate, or the like.

## Claims

1. A semiconductor package comprising:
a resin film (12) having a first, upper surface on which conductive patterns (18) are formed and at least one semiconductor element (16) is to be mounted and a second, lower surface;
a base substrate (10) having a first, upper surface on which intermediate conductive patterns (27) are formed and a second, lower surface on which external terminal connecting pads (24) to which external terminals (26) are to be connected are formed, said intermediate conductive patterns (27) are electrically connected to said external terminal connecting pads (24) by means of vias (22) provided in said base substrate;
an adhesive layer (14) for adhering said second, lower surface of the resin film (12) to said first, upper surface of the base substrate (1); and
connecting means (30,40,42) provided in through holes (28) penetrating through said resin film (12) and in said adhesive layer (14) for electrically connecting said conductive patterns (18) on said first, upper surface of the resin film (12) to said external terminal connecting pads (24) on said second, lower surface of the base substrate (10) by means of said intermediate conductive patterns (27) on the first, upper surface of the base substrate (10).

2. A semiconductor package according to claim 1, wherein said connecting means for electrically connecting said conductive patterns (18) to said external terminal connecting pads (24) comprises said through holes (28) penetrating through said resin film (12) and said adhesive layer (14) being filled with conductive paste (30) or being plated (36) on their inner walls.

3. A semiconductor package according to claim 1, wherein said connecting means comprises metal plated layers (36) formed on inner walls of said through holes (28), and portions (40) of said anisotropic conductive adhesive paste at locations corresponding to said through holes (28).

4. A semiconductor package according to any one of the preceding claims, wherein said conductive patterns (18) on the first, upper surface of the resin film (12) are finer than said intermediate conductive patterns (27) on the first, upper surface of the base substrate (10).

5. A semiconductor package according to any one of the preceding claims, wherein each of said vias (20) provided in the base substrate (10) comprises a through hole provided in said base substrate (10) and a metal plated layer (22) formed on the inner wall of said through hole and/or said through hole is filled with conductive paste (46).

6. A semiconductor package according to any one of the claims, wherein said base substrate (10) comprises a glass fiber reinforced plastic substrate or a ceramic substrate.

7. A semiconductor device comprising a semiconductor package in accordance with any one of the preceding claims,
at least one semiconductor element (16) mounted on said conductive patterns (18) on the first, upper surface of the resin film (12); and
a sealing resin (34) for hermetically sealing and covering the at least one said semiconductor element (16).

8. A process for making a semiconductor package comprising:
preparing a base substrate (10) having a first, upper surface on which intermediate conductive patterns (27) are formed and a second, lower surface on which external terminal connecting pads (24) to which external terminals (26) are to be connected are formed, said intermediate conductive patterns (27) are electrically connected to said external terminal connecting pads (24) by means of vias (20) provided in said base substrate (10);
preparing a resin film (12) having a first, upper surface on which conductive patterns (18) are formed and a second, lower surface;
adhering said second, lower surface of the resin film (12) to said first, upper surface of the base substrate (10) by means of an adhesive layer (14);
providing through holes (28) so as to penetrate through at least said resin film (12) at positions corresponding to said intermediate conductive patterns (27) of the base substrate (10); and
filling said through holes with conductive paste (30) or forming metal plated layers (42) on their inner walls to electrically connect said conductive patterns (18) on said first, upper surface of the resin film (12) to said external terminal connecting pads (24) on said second, lower surface of the base substrate (10) by means of said intermediate conductive patterns (27) of the base substrate (10).

9. A process for making a semiconductor package according to claim 8, wherein said adhesive layer comprises an anisotropic conductive adhesive paste (38,40) ; and
wherein metal plated layers (36) are formed on said inner walls of said through holes (28) to electrically connect said conductive patterns (18) on said first, upper surface of the resin film (12) to said external terminal connecting pads (24) on said second, lower surface of the base substrate (10) by means of said anisotropic conductive adhesive paste (40) and said intermediate conductive patterns (27) of the base substrate (10).
